(19) Europäisches Patentamt
European Patent Office
Office européen des brevets

(11) **EP 4 421 124 A1**

(12) **EUROPEAN PATENT APPLICATION**
published in accordance with Art. 153(4) EPC

(43) Date of publication:
**28.08.2024 Bulletin 2024/35**

(21) Application number: **22883222.6**

(22) Date of filing: **01.09.2022**

(51) International Patent Classification (IPC):
*C08L 75/04* (2006.01)   *C08G 18/65* (2006.01)
*C08G 18/80* (2006.01)   *C08K 3/08* (2006.01)
*C09J 7/30* (2018.01)   *C09J 9/02* (2006.01)
*C09J 175/02* (2006.01)   *C09J 175/04* (2006.01)
*H01B 1/22* (2006.01)   *H05K 3/32* (2006.01)

(52) Cooperative Patent Classification (CPC):
**C08G 18/65; C08G 18/80; C08K 3/08; C08L 75/04;
C09J 7/30; C09J 9/02; C09J 175/02; C09J 175/04;
H01B 1/22; H05K 3/32**

(86) International application number:
**PCT/JP2022/032963**

(87) International publication number:
**WO 2023/067910 (27.04.2023 Gazette 2023/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.10.2021 JP 2021173048**

(71) Applicant: **Toyobo Co., Ltd.**
**Kita-ku**
**Osaka-shi, Osaka 530-0001 (JP)**

(72) Inventors:
• **TAKIMOTO, Naomi**
  **Otsu-shi, Shiga 520-0292 (JP)**
• **IRIE, Michihiko**
  **Otsu-shi, Shiga 520-0292 (JP)**
• **KONDO, Takashi**
  **Otsu-shi, Shiga 520-0292 (JP)**

(74) Representative: **Müller-Boré & Partner**
**Patentanwälte PartG mbB**
**Friedenheimer Brücke 21**
**80639 München (DE)**

(54) **ELECTROCONDUCTIVE COMPOSITION**

(57)    An object of the present invention is to provide an electroconductive composition capable of preparing a flexible cured product having excellent electroconductivity and adhesiveness at a lower temperature, and an electronic device prepared therefrom.

The present invention relates to an electroconductive composition comprising a polyol, a polyamine, a blocked isocyanate, and electroconductive particles, wherein the polyamine has an active hydrogen equivalent ratio of 80 g/eq to 200 g/eq, the polyamine has an amine value of 150 KOHmg/g to 350 KOHmg/g, and the polyamine has a viscosity of 50 mPa·s to 500 mPa·s at 25 °C.

EP 4 421 124 A1

**Description**

TECHNICAL FIELD

The present invention relates to an electroconductive composition having flexibility and an electronic device thereof.

BACKGROUND ART

Flexible hybrid electronics (hereinafter, referred to as FHE) has been developed in association with expansion of uses of electronic devices. In the FHE, a semiconductor part such as a chip or a capacitor is mounted on a wire formed on a flexible base material. However, the semiconductor part is rigid and cannot be deformed, and thus a connection portion between the semiconductor part and the wire is required to be made of a flexible and low-elasticity electroconductive adhesive that can follow deformation of the base material so as to be able to maintain the connection of the part even at the time of the deformation.

As a base material of the FHE, a flexible base material such as polyethylene terephthalate (PET), polyethylene naphthalate (PEN), polypropylene (PP), and polyurethane (PU), which are inferior in heat resistance to a base material used for an existing electronic device, is used in some cases. Therefore, the electroconductive adhesive for joining the part is also required to achieve adhesion at a low temperature corresponding to the heat resistance of the base material.

In view of this requirement, Patent Literature 1 discloses a technology in which silver powder and/or silver coat metal powder is combined with a liquid epoxy resin and a liquid phenoxy resin, and a latent glutaric acid generating compound is added thereto in a given amount, for the purpose of providing an electroconductive adhesive that controls increase in the viscosity thereof at room temperature and that has excellent electrical conductivity and adhesion strength.

In addition, Patent Literature 2 discloses a technology of an electroconductive adhesive having favorable flexibility and high electrical conductivity in which silver particles are combined with a polyether polymer that has a hydrolyzable silyl group as a terminal group and that has a main chain having a repeating unit represented by the formula $-R^1-O-$ (in the formula, $R^1$ is a hydrocarbon group having 1 to 10 carbon atoms).

Patent Literature 3 discloses a technology relating to an electroconductive composition having excellent tackiness before curing and having a small change in the resistance when being stretched after curing in which a polyol, a blocked isocyanate, and an electroconductive filler having an aspect ratio of 2 or higher are combined.

Patent Literature 4 discloses a technology of an electroconductive composition having improved electrical conductivity in which an electroconductive metal having a metal oxide and a lubricant present on a surface thereof and an isocyanate component are reacted with each other at the time of heating and curing, the metal oxide and the lubricant are at least partially eliminated from the surface of the electroconductive metal.

CITATION LIST

PATENT LITERATURE

[PTL 1] Japanese Patent No. 5200662
[PTL 2] Japanese Laid-Open Patent Publication No. 2018-48286
[PTL 3] Japanese Laid-Open Patent Publication No. 2020-150236
[PTL 4] Japanese Patent No. 4467439

SUMMARY OF THE INVENTION

PROBLEMS TO BE SOLVED BY THE INVENTION

As described above, a flexible electroconductive adhesive that can follow deformation of a base material has been currently required. However, although an electroconductive adhesive used for an ordinary electronic device such as the electroconductive adhesive in Patent Literature 1 has excellent adhesive force and electrical conductivity, the electroconductive adhesive has a problem of lacking flexibility. Meanwhile, the electroconductive adhesive disclosed in Patent Literature 2 has excellent flexibility and specific resistance, and there is a problem of requiring a high curing temperature. Furthermore, the electroconductive adhesives in which a blocked isocyanate is used as a curing agent as disclosed in Patent Literature 3 and Patent Literature 4 can be cured at a low temperature and have excellent electrical conductivity, and the flexibility and the adhesiveness of the electroconductive adhesives are not sufficiently studied.

SOLUTION TO THE PROBLEMS

The present inventors conducted thorough studies to develop an electroconductive composition for obtaining a cured product that is flexible and that has high electrical conductivity and adhesive force in the case of a low curing temperature. As a result, the present inventors have found that a flexible cured product having excellent electrical conductivity and adhesiveness is obtained by combining a specific polyamine and electroconductive particles in addition to a polyol and a blocked isocyanate which form a binder. Consequently, the present inventors have arrived at the following invention.

That is, the present invention has the following features:

[1] An electroconductive composition comprising a polyol, a polyamine, a blocked isocyanate, and electroconductive particles, wherein

the polyamine has an active hydrogen equivalent weight of 80 g/eq to 200 g/eq,
the polyamine has an amine value of 150 KOHmg/g to 350 KOHmg/g, and
the polyamine has a viscosity of 50 mPa·s to 500 mPa·s at 25 °C.

[2] The electroconductive composition according to the above [1], wherein a mixing ratio of the polyol to the polyamine is 7/3 to 2/8 as an active hydrogen equivalent ratio.

[3] The electroconductive composition according to the above [1] or [2], wherein the electroconductive particles are silver particles.

[4] A cured product of the electroconductive composition as defined in any one of the above [1] to [3].

[5] An electronic device comprising an electronic part and a substrate having an electrical wire, wherein the cured product of the electroconductive composition as defined in the above [4] is interposed between the electronic part and the electrical wire.

[6] The electronic device according to the above [5], wherein the substrate is a stretchable and/or bendable substrate.

ADVANTAGEOUS EFFECTS OF THE INVENTION

The present invention is characterized by blending, in addition to a polyol, a blocked isocyanate, and electroconductive particles, a polyamine having an active hydrogen equivalent weight of 80 g/eq or higher and 200 g/eq or lower, an amine value of 150 KOHmg/g or higher and 350 KOHmg/g or lower, and a viscosity at 25°C of 50 mPa·s or higher and 500 mPa·s or lower. Since the polyamine is used, the handleability of the electroconductive composition is improved. Furthermore, the adhesiveness at the interface between the electroconductive particles and the binder is improved, whereby it is possible to improve the adhesive force of an obtained cured product while maintaining the flexibility thereof. Furthermore, it becomes easy for the electroconductive particles to form networks, whereby the electrical conductivity of the obtained cured product can be improved.

BRIEF DESCRIPTION OF THE DRAWING

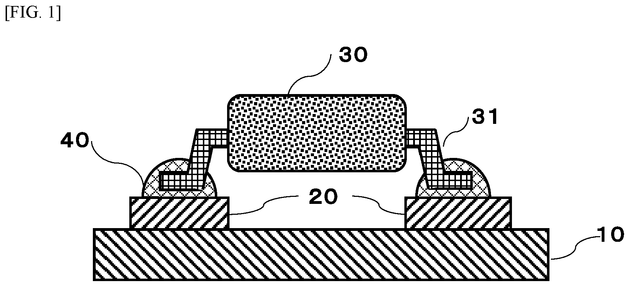

[FIG. 1] FIG. 1 is a schematic diagram showing a cross section of an electronic device in which an electroconductive composition of the present invention is used.

DESCRIPTION OF EMBODIMENTS

[Electroconductive Composition]

An electroconductive composition according to the present embodiment contains at least a polyol, a polyamine, a blocked isocyanate, and electroconductive particles.

Examples of the polyol in the present invention include polyether polyols, polyester polyols, polycarbonate polyols, polyurethane polyols, polybutadiene polyols, polyisoprene polyols, polycaprolactone polyols, and castor oil-based polyols. These polyols may be used singly, or two or more types of these polyols may be used in combination.

Example of the polyether polyols include aromatic polyether polyols, aromatic-aliphatic copolymerized polyether polyols, aliphatic polyether polyols, and alicyclic polyether polyols.

Examples of the polyester polyols include aromatic polyester polyols, aromatic-aliphatic copolymerized polyester polyols, aliphatic polyester polyols, and alicyclic polyester polyols. Among these polyester polyols, an aliphatic polyester polyol is preferable from the viewpoint of flexibility. Specific examples of a commercially available product of the aliphatic polyester polyol include: ODX-2420 and ODX-2692 (manufactured by DIC CORPORATION); KURARAY POLYOL P-510, KURARAY POLYOL P-1010, and KURARAY POLYOL P-2050 (manufactured by KURARAY CO., LTD.); and NIPPOLLAN 4009, NIPPOLLAN 164, and NIPPOLLAN 141 (manufactured by TOSOH CORPORATION).

Examples of the polycarbonate polyols include aromatic polycarbonate polyols, aromatic-aliphatic copolymerized polycarbonate polyols, aliphatic polycarbonate polyols, and alicyclic polycarbonate polyols.

Examples of the polyurethane polyols include aromatic polyurethane polyols, aromatic-aliphatic copolymerized polyurethane polyols, aliphatic polyurethane polyols, and alicyclic polyurethane polyols.

Among these polyols, a polyester polyol is likely to improve curability and electrical conductivity, and thus, is preferable. It is also preferable to combine the polyester polyol and a polyol other than polyester polyol. The proportion of the polyester polyol in the polyol is preferably 60% by mass or higher, more preferably 80% by mass or higher, further preferably 90% by mass or higher, particularly preferably 95% by mass or higher, and most preferably 98% by mass or higher, and may be 100% by mass.

The polyol has an active hydrogen equivalent weight of preferably 180 g/eq or higher and more preferably 220 g/eq or higher from the viewpoint of the flexibility of the cured product. Meanwhile, the active hydrogen equivalent weight is preferably 1200 g/eq or lower and more preferably 600 g/eq or lower from the viewpoint of the adhesiveness and the electrical conductivity of the cured product. If the active hydrogen equivalent weight is set to fall within the above range, the balance among the flexibility, the adhesiveness, and the electrical conductivity of the cured product becomes more favorable. The active hydrogen equivalent weight of the polyol is measured according to a method described in EXAMPLES.

The polyol has a hydroxyl value, which is not particularly limited but is preferably 50 to 300 mgKOH/g and further preferably 100 to 250 mgKOH/g from the viewpoint of obtaining more favorable electrical conductivity and adhesiveness.

The polyol has a weight-average molecular weight, which is not particularly limited but is preferably 400 to 2000 g/mol and further preferably 450 to 1500 g/mol from the viewpoint of obtaining more favorable electrical conductivity and adhesiveness.

In addition to the polyol component, a compound having one hydroxy group may be further contained unless performances are impaired. Examples of the compound having one hydroxy group include: aliphatic saturated alcohols such as 1-pentanol, octanol, and cyclohexane ethanol; aliphatic unsaturated alcohols such as 10-undecen-1-ol; aromatic alcohols such as 2-phenylethyl alcohol and benzyl alcohol; and furthermore, derivatives and modified products of these compounds. The amount of the compound having one hydroxy group contained per 100 parts by mass of the polyol is preferably 10 parts by mass or smaller, more preferably 5 parts by mass or smaller, and further preferably 3 parts by mass or smaller, and may be 0 parts by mass.

The polyamine in the present invention has an active hydrogen equivalent weight of 80 g/eq or higher and 200 g/eq or lower, an amine value of 150 KOHmg/g or higher and 350 KOHmg/g or lower, and a viscosity at 25°C of 50 mPa·s or higher and 500 mPa·s or lower.

If the active hydrogen equivalent weight of the polyamine is 80 g/eq or higher, the flexibility of the cured product is improved, the storage modulus of the cured product does not become excessively high, and cracks are less likely to be generated at the time of deformation. Considering this, the active hydrogen equivalent weight is preferably 82 g/eq or higher and more preferably 85 g/eq or higher. Meanwhile, if the active hydrogen equivalent weight is 200 g/eq or lower, the adhesive force and the electrical conductivity of the cured product are improved. Considering this, the active hydrogen equivalent weight is preferably 195 g/eq or lower and more preferably 190 g/eq or lower. The active hydrogen equivalent weight of the polyamine is measured according to a method described in EXAMPLES.

The amine value of the polyamine is preferably 160 KOHmg/g or higher and more preferably 170 KOHmg/g or higher, and meanwhile, is preferably 330 KOHmg/g or lower and more preferably 300 KOHmg/g or lower. If the amine value of the polyamine is within the aforementioned range, increase in the viscosity of the electroconductive composition is controlled due to an interaction between the polyamine and the electroconductive particles and becomes easy to handle. The amine value of the polyamine is measured according to a method described in EXAMPLES.

The viscosity at 25°C of the polyamine is preferably 55 mPa·s or higher and more preferably 60 mPa·s or higher, and meanwhile, is preferably 490 mPa·s or lower and more preferably 480 mPa·s or lower. If the viscosity at 25°C of the polyamine is within the aforementioned range, the viscosity of the electroconductive composition becomes favorable, and the electroconductive composition becomes easy to handle. The viscosity at 25°C of the polyamine is measured according to a method described in EXAMPLES.

That is, when the active hydrogen equivalent weight, the amine value, and the viscosity at 25°C of the polyamine in the present invention are set to fall within the above respective predetermined ranges, the flexibility, the adhesiveness, the electrical conductivity, and the handleability become favorable.

Examples of the polyamine used in the present invention include: aliphatic polyamines such as chain aliphatic polyamines, cyclic aliphatic polyamines, and aromatic ring aliphatic polyamines; alicyclic polyamines; aromatic polyamines; and furthermore, derivatives and modified products of these polyamines. These polyamines may be used singly, or two or more types of these polyamines may be used in combination. Examples of the derivatives include alkyl derivatives of the polyamines, and examples of the modified products include: epoxy adducts of the polyamines; Mannich reaction products of the polyamines; Michael reaction products of the polyamines; thiourea reaction products of the polyamines; and polymerized fatty acid and/or carboxylic acid reaction products of the polyamines, which are polyamide amines.

The aliphatic polyamines are compounds in each of which at least one amino group is bound to a chain aliphatic hydrocarbon having one or more carbon atoms (excluding compounds each having structure in which an amino group has been directly bound to an aromatic ring), and an aliphatic ring or an aromatic ring may be bound to the chain aliphatic hydrocarbon. In particular, a compound in which an amino group and an aliphatic ring are bound to the chain aliphatic hydrocarbon is referred to as a cyclic aliphatic polyamine, and a compound in which an amino group and an aromatic ring are bound to the chain aliphatic hydrocarbon is referred to as an aromatic ring aliphatic polyamine. Specific examples of the aliphatic polyamines include diethylenetriamine, triethylenetetramine, tetraethylenepentamine, norbornanediamine, m-xylenediamine, and isophorone diamine.

The alicyclic polyamines are compounds in each of which all amino groups are directly bound to an aliphatic ring. Specific examples of the alicyclic polyamines include cyclohexanediamine.

The aromatic polyamines are compounds in each of which at least one amino group is directly bound to an aromatic ring. Specific examples of the aromatic polyamines include diethyltoluenediamine, dimethylthiotoluenediamine, 4,4'-methylenebis[N-(1-methylpropyl)aniline], and aminobenzylamine.

Among these polyamines, an aliphatic polyamine or a modified product thereof is preferable in the viewpoint of easily improving the flexibility. Specific examples of a commercially available product of the aliphatic polyamine or the modified product thereof include: FUJICURE FXJ-8027-H, FUJICURE FXJ-859-C, FUJICURE FXD-821-F, TOHMIDE 280-C, and TOHMIDE TXE-524 (manufactured by T&K TOKA Corporation); JEFFAMINE D-400 (manufactured by TOMOE Engineering Co., Ltd.); and jER CURE FL11 and jER CURE SA1 (manufactured by Mitsubishi Chemical Corporation).

It is also preferable that the aliphatic polyamine or the modified product thereof is combined with a polyamine other than the aliphatic polyamine or the modified product thereof. The proportion of the aliphatic polyamine or the modified product thereof in the polyamine is preferably 60% by mass or higher, more preferably 80% by mass or higher, further preferably 90% by mass or higher, particularly preferably 95% by mass or higher, and most preferably 98% by mass or higher, and may be 100% by mass.

A mixing ratio, as an active hydrogen equivalent weight ratio, of the polyol to the polyamine (polyol/polyamine) in the present invention is preferably 2/8 to 7/3 and more preferably 3/7 to 6/4. When the proportion of the polyamine is increased, the adhesiveness and the electrical conductivity of the obtained cured product can be made favorable, and, when the proportion of the polyol is increased, the flexibility of the obtained cured product can be made favorable. Thus, if the mixing ratio of the polyol to the polyamine is set to fall within the above range, the balance among the flexibility, the adhesiveness, and the electrical conductivity of the cured product becomes more favorable.

The total amount of the polyol and the polyamine in the present invention is not particularly limited but is preferably 1% by mass or higher and 50% by mass or lower, further preferably 2% by mass or higher and 30% by mass or lower, and most preferably 3% by mass or higher and 15% by mass or lower with respect to the amount of the entire electroconductive composition. If the total amount of the polyol and the polyamine is set to fall within this range, the balance between the flexibility and the electrical conductivity becomes more favorable.

As an isocyanate that forms the blocked isocyanate compound used in the present invention, a compound having a plurality of isocyanate groups in the molecule thereof (polyisocyanate) is preferable. Examples of the polyisocyanate include: aliphatic polyisocyanates such as hexamethylene diisocyanate (hereinafter, HDI) and isophorone diisocyanate (IPDI); aromatic polyisocyanates such as diphenylmethane diisocyanate (MDI) and tolylene diisocyanate (TDI); and modified products such as isocyanurates, adducts, and biurets of these polyisocyanates. From the viewpoint of obtaining a more favorable flexibility, an aliphatic polyisocyanate or a modified product of the aliphatic polyisocyanate is preferable.

Each of the isocyanates may be a monomer but is preferably an oligomer of the isocyanate or a modified product such as an isocyanurate, an adduct, or a biuret of the oligomer.

The most preferable isocyanate is an oligomer of any of the aliphatic polyisocyanates such as an oligomer of HDI, or a modified product of the oligomer.

Examples of a blocking agent that forms the above blocked isocyanate compound include phenol-based blocking agents, oxime-based blocking agents, alcohol-based blocking agents, lactam-based blocking agents, active methylene-based blocking agents, and pyrazole-based blocking agents. Among these blocking agents, an active methylene-based blocking agent or a pyrazole-based blocking agent is preferable because of the ability thereof to decrease the temperature for a reaction. These blocking agents may be contained singly, or two or more types of these blocking agents may be contained. From the viewpoint of curability and preservation stability, it is preferable that both an active methylene-based blocking agent and a pyrazole-based blocking agent are contained.

Examples of the above active methylene-based blocking agents include dialkyl malonates such as dimethyl malonate, diethyl malonate, dibutyl malonate, 2-ethylhexyl malonate, methylbutyl malonate, diethylhexyl malonate, and diphenyl malonate.

Examples of the above pyrazole-based blocking agents include pyrazole, 3,5-dimethyl pyrazole, 3-methyl pyrazole, and 4-nitro-3,5-dimethyl pyrazole.

Examples of a commercially available product of the above blocked isocyanate compound can include: Duranate SBN-70D, Duranate SBB-70P, and Duranate TPA-B80E (manufactured by Asahi Kasei Corporation); Desmodur BL 3272 MPA, Desmodur BL 3475 BA/SN, and Desmodur BL 3575 MPA/SN (manufactured by Covestro AG); and Trixene BI 7960, Trixene BI 7982, Trixene BI 7991, and Trixene BI 7992 (manufactured by Baxenden Chemicals Limited).

The blending ratio of the isocyanate group of the blocked isocyanate to all the active hydrogen groups of the polyol and the polyamine (NCO group/active hydrogen group) in the present invention is not particularly limited but is preferably 0.7 or higher and lower than 2.0 and further preferably 0.8 or higher and 1.5 or lower. If the blending ratio is within this range, it is possible to exhibit a more favorable adhesiveness of the cured product while maintaining the flexibility thereof.

In the electroconductive composition of the present invention, a catalyst can be further contained unless the performances are impaired. The catalyst is not particularly limited, and examples of the catalyst include organic tin compounds, organic bismuth metal compounds, and tertiary amine compounds. The amount of the catalyst is preferably 1.0% by mass or lower and more preferably 0.1% by mass or lower with respect to the amount of the entire electroconductive composition.

The electroconductive particles used in the present invention are not particularly limited, and examples of the electroconductive particles include particles of silver, copper, gold, platinum, palladium, aluminum, nickel, indium, bismuth, zinc, lead, tin, and carbon black. These electroconductive particles may be used singly, or two or more types of these electroconductive particles may be used in combination. Among these electroconductive particles, silver particles are preferably used from the viewpoint of electrical conductivity.

The electroconductive particles have an average particle diameter D50, which is not particularly limited but is preferably 0.4 $\mu$m or larger and 15 $\mu$m or smaller. If the D50 is 0.4 $\mu$m or larger, the flexibility of the cured product is improved, the storage modulus of the cured product does not become excessively high, and cracks are less likely to be generated at the time of deformation. Considering this, the D50 is more preferably 0.5 $\mu$m or larger and further preferably 0.6 $\mu$m or larger. Meanwhile, if the D50 is 15 $\mu$m or smaller, the adhesive force and the electrical conductivity of the cured product are improved. Considering this, the D50 is more preferably 12 $\mu$m or smaller and further preferably 10 $\mu$m or smaller.

The electroconductive composition of the present invention may contain one type of electroconductive particles having a single average particle diameter D50 or may contain two or more types of electroconductive particles having different average particle diameters D50. From the viewpoint of improving the adhesive force while maintaining the flexibility, two or more types of electroconductive particles including small-particle-diameter electroconductive particles and large-particle-diameter electroconductive particles are preferably contained. On one hand, the average particle diameter D50 of the small-particle-diameter electroconductive particles is not particularly limited but is preferably 0.4 $\mu$m or larger, more preferably 0.5 $\mu$m or larger, and further preferably 0.6 $\mu$m or larger. Meanwhile, the average particle diameter D50 of the small-particle-diameter electroconductive particles is preferably 2 $\mu$m or smaller, more preferably 1.5 $\mu$m or smaller, and further preferably 1.2 $\mu$m or smaller. On the other hand, the average particle diameter D50 of the large-particle-diameter electroconductive particles is not particularly limited but is preferably 5 $\mu$m or larger, more preferably 6 $\mu$m or larger, and further preferably 7 $\mu$m or larger. Meanwhile, the average particle diameter D50 of the large-particle-diameter electroconductive particles is preferably 15 $\mu$m or smaller, more preferably 12 $\mu$m or smaller, and further preferably 10 $\mu$m or smaller. The blending ratio of the small-particle-diameter electroconductive particles to the large-particle-diameter electroconductive particles (the mass ratio of the small-particle-diameter electroconductive particles to the large-particle-diameter electroconductive particles) is not particularly limited but is preferably 95/5 to 50/50 and further preferably 90/10 to 70/30. If the blending ratio of the small-particle-diameter electroconductive particles to the large-particle-diameter electroconductive particles is set to fall within this range, it is possible to obtain a further flexible cured product while maintaining the electrical conductivity and the adhesiveness thereof.

The average particle diameter D50 in the present invention indicates a particle diameter at a value of 50% in terms of cumulative volume regarding particle diameters measured through a laser diffraction method.

The shapes of the electroconductive particles are not particularly limited, and examples of the shapes include the shapes of flakes, indefinite and aggregate shapes, spherical shapes, and block-like shapes. The electroconductive particles may have one of these types of shapes or may have two or more of these types of shapes. Among these shapes, the electroconductive particles preferably have at least the shapes of flakes from the viewpoint of preventing decrease in the viscosity at the time of heating.

The amount of the electroconductive particles in the present invention is not particularly limited but is preferably 50% by mass or higher and 95% by mass or lower and further preferably 60% by mass or higher and 90% by mass or lower with respect to the amount of the entire electroconductive composition. If the amount of the electroconductive particles is set to fall within this range, the balance between the flexibility and the electrical conductivity becomes more favorable.

The electroconductive composition of the present invention does not have to contain any solvent or may contain a solvent. The amount of the solvent contained in the electroconductive composition is preferably lower than 10% by mass and more preferably lower than 5% by mass. The amount of the solvent may be 0% by mass or may be 1% by mass or higher. If the amount of the solvent is set to fall within the above range, generation of air bubbles can be suppressed at the time of forming a cured product, and the film thickness of the obtained cured product can be increased.

The type of the solvent is not particularly limited, and examples of the solvent include ethyl acetate, butyl acetate, solvent naphtha, propylene glycol monomethyl ether, dipropylene glycol monomethyl ether, propylene glycol monomethyl ether acetate, and propylene glycol monoethyl ether acetate.

In the electroconductive composition of the present invention, it is possible to further blend an additive such as a thermoplastic resin, an inorganic filler, an electroconductive aid, a pigment, a dye, a dispersant, a defoamer, a leveling agent, a thixotropy imparting agent, a reactive diluent, a flame retardant, an antioxidant, an ultraviolet absorber, a hydrolysis inhibitor, a tackifier, or a plasticizer. The blending amount of the additive is preferably 10% by mass or lower, more preferably 3% by mass or lower, and further preferably 1% by mass or lower with respect to the amount of the entire electroconductive composition.

The electroconductive composition of the present invention can be obtained by mixing and dispersing the polyol, the polyamine, and the blocked isocyanate compound which are binder components, the electroconductive particles, and components used as necessary by using a dispersing machine such as a dissolver, a three-roll mill, a rotating/revolving mixer, an attritor, a ball mill, or a sand mill.

The electroconductive composition of the present invention can achieve obtainment of all of flexibility, adhesiveness, and electrical conductivity, and thus, is suitably used as an electroconductive adhesive (preferably, an electroconductive adhesive used for flexible hybrid electronics). The electroconductive composition of the present invention is applied or printed on a substrate and is cured, whereby the cured product can be used as an alternative to solder, for mounting an electronic part. A method for applying the electroconductive composition on the substrate is not particularly limited, and examples of the method include a screen printing method, a stamping method, a dispensing method, and a squeegee printing method. In addition, by curing the electroconductive composition, the cured product can be used for: joining or mounting a semiconductor element chip part; connecting a circuit; adhering a crystal oscillator or a piezoelectric element; sealing a package; or the like.

The heating temperature at the time of curing is determined as appropriate according to the temperature for a reaction between each active hydrogen group and the blocked isocyanate group and the heat resistance of the substrate to be used. The heating temperature may be, for example, 80°C to 150°C or 100°C to 130°C. The heating time is not particularly limited but is preferably about 30 minutes to 60 minutes.

A cured product formed by using the electroconductive composition of the present invention has storage modulus at 25°C measured by using a viscoelasticity measurement device. From the viewpoint of the flexibility, the storage modulus is preferably 50 MPa or higher and 600 MPa or lower and further preferably 150 MPa or higher and 500 MPa or lower. The storage modulus of the cured product is measured according to a method described in

EXAMPLES.

The above cured product has specific resistance of preferably lower than $2.0 \times 10^{-4}$ $\Omega \cdot$cm and further preferably lower than $1.5 \times 10^{-4}$ $\Omega \cdot$cm from the viewpoint of the electrical conductivity. The specific resistance of the cured product is measured according to a method described in EXAMPLES.

The above cured product has shear adhesion force exerted when an oxygen-free copper sheet is used as an adherend. From the viewpoint of the adhesiveness, the shear adhesion force is preferably 2.0 MPa or higher and further preferably 2.4 MPa or higher. The shear adhesion force of the cured product is measured according to a method described in

EXAMPLES.

An electronic device according to the present embodiment includes: a substrate having an electrical wire; an electronic part; and the cured product, of the above electroconductive composition, interposed between the electronic part and the electrical wire. Consequently, the wire formed on the substrate and the electronic part can be physically and electrically connected. FIG. 1 is a schematic cross-sectional view showing an example of the electronic device. This electronic device includes: a substrate 10; an electrical wire 20 formed on a surface of the substrate 10; an electronic part 30; and a cured product 40, of the electroconductive composition, interposed between each of the electrical wire 20 and the electronic part 30 (more specifically, a corresponding one of electrodes 31 formed on the electronic part 30). The electronic part 30 and the electrical wire 20 are electrically connected by the cured product 40.

The substrate of the electronic device according to the present embodiment may be a stretchable and/or bendable substrate. The cured product of the above electroconductive composition has flexibility, and thus, can follow stretching and bending of the substrate, whereby cracking and peeling at the connection portion between the electronic part and the electrical wire are suppressed. Therefore, the electronic device according to the present embodiment is flexible and still has high reliability in connection.

The stretchable and/or bendable substrate used in the present invention is not particularly limited, and examples of the substrate include fiber structures, resin films, and rubbers. Examples of the fiber structures include knitted fabric, woven fabric, nonwoven fabric, and paper. Examples of the resin films include polyethylene terephthalate, polyvinyl chloride, polyethylene, polypropylene, polycarbonate, polyethylene naphthalate, polyurethane, polyimide, polymethyl methacrylate, and silicone. Examples of the rubbers include urethane rubber, acrylic rubber, silicone rubber, butadiene rubber, nitrile group-containing rubbers such as nitrile rubber and hydrogenated nitrile rubber, isoprene rubber, vulcanized rubber, styrenebutadiene rubber, butyl rubber, and ethylene-propylene rubber.

EXAMPLES

Hereinafter, the present invention will be specifically described in more detail by means of Examples. Operations, evaluation results, and the like regarding the Examples are based on the measurements performed through the following methods.

<Amine Value>

The amine value of each of polyamines was obtained as follows. That is, 1 g of a sample was dissolved in 50 g of a phenol-methanol (mass ratio: 50/50) mixed solution, titration was performed with a 1/10N hydrochloric acid-methanol solution by using bromophenol blue as an indicator, and the amine value was indicated as a mg number of KOH per gram of resin.

<Active Hydrogen Equivalent Weight of Polyamine>

The active hydrogen equivalent weight of each of the polyamines was calculated on the basis of the backbone structure thereof according to the following expression (i).

$$\text{Active hydrogen equivalent weight of polyamine (g/eq)}$$
$$= \text{molecular weight of polyamine/number of nitrogen atoms with active hydrogens} \quad \text{(i)}$$

<Hydroxyl Value of Polyol>

The hydroxyl value of a polyol was measured as follows. First, 12.5 g of acetic anhydride was dissolved in 50 mL of pyridine so as to accurately fill up the measuring flask, whereby an acetylating reagent was prepared. Then, 2.5 to 5.0 g (this mass is defined as e (g)) of a sample (polyol) was accurately weighed out and supplied into a 100 mL round-bottom flask, and 5 mL of the acetylating reagent and 10 mL of toluene were added to the sample by using a transfer pipette. Then, a cooling tube was attached, and the mixture was stirred and heated at 100°C for one hour. Then, 2.5 mL of distilled water was added to the mixture by using a transfer pipette, and the mixture was further heated and stirred for 10 minutes. After the mixture was cooled for two to three minutes, 12.5 mL of ethanol was added to the mixture, and two to three drops of phenolphthalein were dripped thereinto as an indicator. Then, titration was performed with a 0.5 mol/L ethanolic potassium hydroxide (the titer obtained is defined as a (mL)). Meanwhile, a blank test was performed as follows. That is, 5 mL of the acetylating reagent, 10 mL of toluene, and 2.5 mL of distilled water were supplied into a 100 mL round-bottom flask, the mixture was heated and stirred for 10 minutes, and then, titration was performed in the same manner (the titer obtained is defined as b (mL)). A hydroxyl value was calculated according to the following expression (ii) on the basis of these results. In expression (ii), f represents a factor of the titrant (0.5 mol/L ethanolic potassium hydroxide).

$$\text{Hydroxyl value of polyol (mg-KOH/g)}$$
$$= \{(b-a)\times 28.05 \times f\}/e \quad \text{(ii)}$$

<Active Hydrogen Equivalent Weight of Polyol>

The active hydrogen equivalent weight of the polyol was obtained according to the following expression (iii) on the basis of the obtained hydroxyl value of the polyol.

$$\text{Active hydrogen equivalent weight of polyol (g/eq)}$$
$$= 56.11/(\text{hydroxyl value} \times 10^{-3}) \quad \text{(iii)}$$

<Viscosity>

As the viscosity of each of the polyamines, a viscosity at a temperature of 25°C was measured by using a type E viscometer (TVE-25H manufactured by Toki Sangyo Co., Ltd.).

<Applicability>

Among electroconductive compositions, an electroconductive composition that had fluidity and that was applicable by using an applicator was determined to be 'good', and an electroconductive composition that did not have fluidity and that was not applicable by using an applicator was determined to be 'bad'.

<Storage Modulus>

Each of the electroconductive compositions was applied on a Teflon (registered trademark) film by using a 200-μm-gap applicator. The electroconductive composition was heated by using a hot-air dryer at 130°C for 60 minutes so as to be cured, and then, was cooled to room temperature. Then, the resultant coating film was cut into a size of 4 mm×300 mm and peeled from the Teflon film, whereby a test piece for storage modulus evaluation was obtained. The test piece was set on a viscoelasticity measurement device (DVA-200 manufactured by IT Keisoku Seigyo Kabushiki Kaisha (provisional translation: IT Measurement & Control Corporation)), and the device was moved under the conditions of a strain of 0.1%, a frequency of 10 Hz, a temperature increase rate of 4°C/min, and a measurement temperature range of -10°C to 100°C, whereby storage modulus at 25°C was obtained.

<Specific Resistance>

Each of the electroconductive compositions was applied on a PET film by using a 50-μm-gap applicator. The electroconductive composition was heated by using a hot-air dryer at 130°C for 60 minutes so as to be cured, and then, was cooled to room temperature. Then, the resultant coating film was cut into a size of 10 mm×35 mm, whereby a test piece for specific resistance evaluation was obtained. The film thickness of the test piece was measured by using a thickness gauge (SMD-565L manufactured by TECLOCK Co., Ltd.), and the sheet resistance of the test piece was measured by using Loresta-GP (MCP-T610 manufactured by Mitsubishi Chemical Analytech Co., Ltd.). The measurement was performed on four such test pieces, and, by using the average value of the four measurement values, specific resistance was calculated to obtain electrical conductivity.

<Adhesiveness>

In order to evaluate the adhesiveness of each of the electroconductive compositions, two oxygen-free copper sheets (dimensions: 25 mm×100 mm×1 mm, material: C1020P, hardness: 1/2H) were used as adherends. The surfaces of the adherends were cleaned with acetone. Then, the electroconductive composition was applied on one of the copper sheets so as to be spread over an area of 25 mm×12.5 mm, and the other copper sheet was pasted on the electroconductive composition. The electroconductive composition was heated by using a hot-air dryer at 130°C for 60 minutes so as to be cured, and then, was cooled to room temperature. The adhesive force was measured in a shear direction at a tension speed of 10 mm/min in an environment of 23°C and a relative humidity of 50%, by using a precision universal tester (AG-20kNXDplus manufactured by Shimadzu Corporation).

Examples 1 to 4 and Comparative Examples 1 to 4

<Manufacturing Example of Electroconductive Composition>

Various components were added according to each of the blending ratios in Table 1 and were premixed. Then, the mixture was dispersed by using a three-roll mill, to be made into a paste. Consequently, an electroconductive composition was obtained. The evaluation results regarding the obtained electroconductive composition are indicated in Table 1.

[Table 1]

| | | Ex. 1 | Ex. 2 | Ex. 3 | Ex. 4 | Com. Ex. 1 | Com. Ex. 2 | Com. Ex. 3 | Com. Ex. 4 |
|---|---|---|---|---|---|---|---|---|---|
| **Composition (% by mass)** | Polyol | 4.4 | 4.4 | 5.7 | 2.3 | 4.9 | 4.2 | 4.8 | 4.4 |
| | Polyamine 1 | 1.5 | | 0.8 | | | | | |
| | Polyamine 2 | | 3.3 | | 4.1 | | | | |
| | Polyamine 3 | | | | | 1.3 | | | |
| | Polyamine 4 | | | | | | 3.8 | | |
| | Polyamine 5 | | | | | | | 1.6 | |
| | Polyamine 6 | | | | | | | | 3.3 |
| | Isocyanate | 12.7 | 12.7 | 12.0 | 14.0 | 14.2 | 12.4 | 14.0 | 12.7 |
| | Electroconductive particles 1 | 73.3 | 39.8 | 61.1 | 39.8 | 39.8 | 39.8 | 39.8 | 39.8 |
| | Electroconductive particles 2 | 8.1 | | 20.4 | | | | | |
| | Electroconductive particles 3 | | 39.8 | | 39.8 | 39.8 | 39.8 | 39.8 | 39.8 |
| **Active hydrogen equivalent weight ratio of polyol to polyamine** | | 5/5 | 5/5 | 7/3 | 3/7 | 5/5 | 5/5 | 5/5 | 5/5 |
| **NCO group/active hydrogen group** | | 0.8 | 0.8 | 0.8 | 1.0 | 0.8 | 0.8 | 0.8 | 0.8 |
| **Evaluation** | Applicability | Good | Good | Good | Good | Good | Good | Bad | Bad |
| | Storage modulus (MPa) | 380 | 210 | 290 | 280 | 2700 | 350 | - | - |
| | Adhesive force (MPa) | 2.7 | 2.5 | 2.4 | 2.8 | 1.3 | 1.2 | - | - |
| | Electrical conductivity (Ω·cm) | $6.8\times10^{-5}$ | $9.5\times10^{-5}$ | $1.1\times10^{-4}$ | $9.1\times10^{-5}$ | $1.6\times10^{-3}$ | $5.8\times10^{-4}$ | - | - |

The components in Table 1 are as follows.
Polyol: polyester polyol P-510 (active hydrogen equivalent weight: 250 g/eq, hydroxyl value: 224 KOHmg/g, weight-average molecular weight: 500 g/mol) available from KURARAY CO., LTD.
Polyamine 1: modified aliphatic amine FXD-821-F (active hydrogen equivalent weight: 85 g/eq, amine value: 300 KOHmg/g, viscosity: 65 mPa s) available from T&K TOKA Corporation
Polyamine 2: modified aliphatic amine FXJ-859-C (active hydrogen equivalent weight: 190 g/eq, amine value: 170 KOHmg/g, viscosity: 450 mPa s) available from T&K TOKA Corporation
Polyamine 3: m-xylenediamine as an aromatic ring aliphatic amine (active hydrogen equivalent weight: 68 g/eq, amine value: 824 KOHmg/g, viscosity: 6 mPa s) available from Tokyo Chemical Industry Co., Ltd.
Polyamine 4: polyoxypropylenediamine D400 (active hydrogen equivalent weight: 224 g/eq, amine value: 415 KOHmg/g, viscosity: 27 mPa s) available from Huntsman International LLC.
Polyamine 5: polyaminoamide 280-C (active hydrogen equivalent weight: 80 g/eq, amine value: 415 KOHmg/g, viscosity: 475 mPa·s) available from T&K TOKA Corporation

Polyamine 6: modified aliphatic amine 8113 (active hydrogen equivalent weight: 190 g/eq, amine value: 280 KOHmg/g, viscosity: 850 mPa·s) available from T&K TOKA Corporation

Isocyanate: blocked isocyanate BI 7992 (NCO: an equivalent weight of 456 g/eq) available from Baxenden Chemicals Limited

Electroconductive particles 1: flake silver P791-24 (D50: 0.7 μm) available from Metalor Technologies Japan K.K.

Electroconductive particles 2: block-like silver P853-11 (D50: 8.0 μm) available from Metalor Technologies Japan K.K.

Electroconductive particles 3: block-like silver P318-41 (D50: 9.0 μm) available from Metalor Technologies Japan K.K.

In each of Examples 1 to 4, a polyamine having an active hydrogen equivalent weight of 80 g/eq or higher and 200 g/eq or lower, an amine value of 150 KOHmg/g or higher and 350 KOHmg/g or lower, and a viscosity at 25°C of 50 mPa·s or higher and 500 mPa·s or lower was contained in addition to a polyol, a blocked isocyanate, and electroconductive particles, whereby a flexible cured product having high electrical conductivity and adhesiveness was able to be obtained. In each of Examples 1 and 2, the physical properties were able to be exhibited regardless of the type of such a polyamine. In each of Examples 3 and 4, the mixing amount of the polyamine with respect to the polyol was increased to improve the adhesiveness, or the mixing amount of the polyamine with respect to the polyol was decreased to obtain a more flexible cured product.

In Comparative Example 1, a polyamine having an active hydrogen equivalent weight of lower than 80 g/eq, an amine value of higher than 350 KOHmg/g, and a viscosity of lower than 50 mPa s was used, whereby a flexible cured product was not able to be obtained. In Comparative Example 2, the active hydrogen equivalent weight was higher than 200 g/eq, whereby the adhesive force and the electrical conductivity deteriorated. In Comparative Example 3, the amine value was higher than 350 KOHmg/g, and, in Comparative Example 4, the viscosity was higher than 500 mPa·s, whereby the viscosity of the electroconductive composition was high, and the electroconductive composition was not able to be handled. Consequently, the electroconductive composition was not able to be applied, and the storage modulus, the adhesive force, and the specific resistance (electrical conductivity) were not able to be measured.

INDUSTRIAL APPLICABILITY

As described above, the electroconductive composition of the present invention allows a flexible cured product having excellent electrical conductivity and adhesiveness to be formed at a low temperature and particularly is very suitable as a joining material between an electronic part and a wire formed on a flexible substrate.

DESCRIPTION OF THE REFERENCE CHARACTERS

10   substrate
20   electrical wire
30   electronic part
31   electrode
40   cured product of electroconductive composition

**Claims**

1. An electroconductive composition comprising a polyol, a polyamine, a blocked isocyanate, and electroconductive particles, wherein

   the polyamine has an active hydrogen equivalent weight of 80 g/eq to 200 g/eq,
   the polyamine has an amine value of 150 KOHmg/g to 350 KOHmg/g, and
   the polyamine has a viscosity of 50 mPa·s to 500 mPa·s at 25 °C.

2. The electroconductive composition according to claim 1, wherein a mixing ratio of the polyol to the polyamine is 7/3 to 2/8 as an active hydrogen equivalent ratio.

3. The electroconductive composition according to claim 1 or 2, wherein the electroconductive particles are silver

EP 4 421 124 A1

particles.

4. A cured product of the electroconductive composition as defined in claim 1 or 2.

5. An electronic device comprising an electronic part and a substrate having an electrical wire, wherein the cured product of the electroconductive composition as defined in claim 4 is interposed between the electronic part and the electrical wire.

6. The electronic device according to claim 5, wherein the substrate is a stretchable and/or bendable substrate.

[FIG. 1]

## INTERNATIONAL SEARCH REPORT

| | International application No. |
|---|---|
| | **PCT/JP2022/032963** |

**A. CLASSIFICATION OF SUBJECT MATTER**

*C08L 75/04*(2006.01)i; *C08G 18/65*(2006.01)i; *C08G 18/80*(2006.01)i; *C08K 3/08*(2006.01)i; *C09J 7/30*(2018.01)i;
*C09J 9/02*(2006.01)i; *C09J 175/02*(2006.01)i; *C09J 175/04*(2006.01)i; *H01B 1/22*(2006.01)i; *H05K 3/32*(2006.01)i
FI:  C08L75/04; C08G18/65 023; C08G18/80; C08K3/08; C09J7/30; C09J9/02; C09J175/02; C09J175/04; H01B1/22 A;
H01B1/22 D; H05K3/32 B

According to International Patent Classification (IPC) or to both national classification and IPC

**B. FIELDS SEARCHED**

Minimum documentation searched (classification system followed by classification symbols)

C08L75/04; C08G18/65; C08G18/80; C08K3/08; C09J7/30; C09J9/02; C09J175/02; C09J175/04; H01B1/22; H05K3/32

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2009/125740 A1 (TOYO BOSEKI KK) 15 October 2009 (2009-10-15) | 1-6 |
| A | WO 2021/200032 A1 (TAIYO INK MFG. CO., LTD.) 07 October 2021 (2021-10-07) | 1-6 |
| A | JP 2020-150237 A (PANASONIC IP MANAGEMENT CORP.) 17 September 2020 (2020-09-17) | 1-6 |
| A | JP 2021-161211 A (TAIYO INK MFG. CO., LTD.) 11 October 2021 (2021-10-11) | 1-6 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **07 October 2022** | **25 October 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/032963**

| Patent document cited in search report | | | Publication date (day/month/year) | Patent family member(s) | Publication date (day/month/year) |
|---|---|---|---|---|---|
| WO | 2009/125740 | A1 | 15 October 2009 | KR 10-2010-0133407 A | |
| WO | 2021/200032 | A1 | 07 October 2021 | (Family: none) | |
| JP | 2020-150237 | A | 17 September 2020 | (Family: none) | |
| JP | 2021-161211 | A | 11 October 2021 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5200662 B
- JP 2018048286 A
- JP 2020150236 A
- JP 4467439 B